# EUROPEAN PATENT APPLICATION

(11) **EP 4 679 056 A1**
(43) Date of publication of application: **14.01.2026**
(21) Application number: 24187250.6
(22) Date of filing: 08.07.2024
(51) Int. Cl.: G01N 1/32, H01J 37/00, H01J 37/26, H01J 37/28

(54) **METHOD FOR CREATING A SAMPLE FOR USE IN A CHARGED PARTICLE MICROSCOPE**

(71) Applicant: FEI COMPANY, Hillsboro, Oregon 97124-5793 (US)
(72) Inventor: SCHAMPERS, Rudolf, Tegelen (NL); PERSOON, Johannes, Waalre (NL)
(74) Representative: Robinson, Louise Frances

(57) **Abstract**

A method for creating a sample for use in a Charged Particle Microscope (CPM). The method comprises the steps of providing a specimen on a specimen carrier. Said specimen comprises a sample area having material from which a sample for use in a Charged Particle Microscope can be created. The sample area also comprises a region of interest that is to be included in said sample. The region of interest can be located in the material. As defined herein, at least one fluorescent fiducial is added to the sample area. Then, a fluorescent technique is used for locating said fluorescent fiducial. Subsequently, the region of interest is identified using said fluorescent technique. Finally, the sample can be created from said material including said region of interest. The method can be performed using a dual-beam FIB/SEM microscope.

## Description

The disclosure relates to a method for creating a sample for use in a Charged Particle Microscope (CPM).

Charged-particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" apparatus (e.g. a FIB-SEM), which additionally employ a "machining" Focused Ion Beam (FIB), allowing supportive activities such as ion-beam milling or lon-Beam-Induced Deposition (IBID), for example. More specifically:
- In a SEM, irradiation of a sample by a scanning electron beam precipitates emanation of "auxiliary" radiation from the sample, in the form of secondary electrons, backscattered electrons, X-rays and photoluminescence (infrared, visible and/or ultraviolet photons), for example; one or more components of this flux of emanating radiation is/are then detected and used for image accumulation purposes.
- In a TEM, the electron beam used to irradiate the sample is chosen to be of a high-enough energy to penetrate the sample (which, to this end, will generally be thinner than in the case of an SEM sample); the flux of transmitted electrons emanating from the sample can then be used to create an image. When such a TEM is operated in scanning mode (thus becoming a STEM), the image in question will be accumulated during a scanning motion of the irradiating electron beam.

Samples need to be prepared for observation in a charged particle microscope. Often, these samples are created from a "bulk sample" (i.e. a larger specimen). This bulk sample or specimen comprises one or more regions of interest that are desirable to be included in the sample. Including the region of interest in the sample requires locating a sample area that contains the region of interest, identifying the region of interest, and creating the sample from said sample area including said region of interest. The process of creating the sample may involve creating thin slices (or sections) by cutting or milling a relevant part of the specimen in a grid or tube. The cutting or milling can be performed by a focused ion beam (FIB) system, or within a dual beam system that includes both a FIB and an electron microscope.

Sample preparation, including the process of identification of the region of interest, is challenging. Finding the correct location and creating the sample from that location requires a lot of accuracy to ensure that the region of interest is included in the final sample. In the dual beam system, for example, it requires a good alignment between the FIB and the electron microscope, so that the region of interest that is identified using the electron microscope is then identified using the FIB and can be extracted from the sample using that FIB. To improve alignment, markers can be created using the FIB to remove material near the region of interest. Although this provides improved results in aligning the FIB to the electron microscope, it still poses challenges for actually extracting the desired region of interest into the final sample.

Thus, from the above it follows that there is a need for a more accurate method of preparing a sample for charged particle microscopy, in particular wherein a region of interest can be more easily identified and included in a final sample.

To this end, the disclosure provides a method for creating a sample for use in a Charged Particle Microscope (CPM), as defined in claim 1.

The method as described herein comprises the steps of providing a specimen on a specimen carrier. The specimen (i.e. "bulk sample") comprises a sample area having material from which a sample for use in a Charged Particle Microscope can be created. Said sample area comprises a region of interest that is to be included in said sample.

The method as described herein comprises the step of locating the sample area on said specimen carrier and identifying the region of interest, after which the sample can be created from said material including said region of interest.

As described herein, the disclosure provides the steps of adding at least one fluorescent fiducial to the sample area; and using a fluorescent technique for locating said fluorescent fiducial for subsequently performing the step of identifying said region of interest.

As defined herein, the fluorescent fiducials are positioned on a surface area of the specimen. By adding the fluorescent fiducials to the surface area of the specimen, they become part of the external surface of the specimen, and thus they will be more visible in any imaging technique, including an electron beam imaging technique, focused ion beam imaging technique and/or a fluorescent imaging technique. This makes identification of the fluorescent fiducials, and subsequently identification of the region of interest more accurate and more easy to perform.

The fluorescent fiducials added to the surface area of the specimen thus allow for a fluorescent technique to be used in identifying the region of interest with more accuracy. The fluorescent fiducials allow, for example, a 3D position of the region of interest inside the specimen to be measured and/or defined otherwise. With this, the object as defined herein is achieved.

Advantageous embodiments will be described below.

In an embodiment, the method comprises the step of determining coordinates of the at least one fluorescent fiducial added to the sample area. Determining coordinates may aid in determining the position of the region of interest and ensures that the region of interest can be included in the final sample.

In an embodiment, the fluorescent technique comprises the use of a fluorescent microscope.

The fluorescent technique may be used to determine the 3D position of the at least one fluorescent fiducial. This can be done by obtaining a first (fluorescent) image of the sample area, said sample area including the fluorescent fiducial. For obtaining the first image use can be made of the fluorescent microscope. Additionally, at least a second image of the sample area is obtained, wherein use may be made of the fluorescent microscope, wherein the second image is obtained at a different focal plane (Z-height) compared to the first image. A total of N images may be obtained (N ≥ 2), each at different focal planes. In effect, a Z-stack is created using a total of N images, wherein preferably N ≥ 5, more in particular N ≥ 10. From this Z-stack of N images, each individual image may be used to identify the XY positions of the fluorescent fiducials in that corresponding image (position in the image plane), and the Z-stack provides the Z coordinate for the fluorescent fiducial (position perpendicular to the image plane). Thus, the fluorescent imaging technique may be used to determine the 3D position of the fluorescent fiducial, and with this the region of interest can be more accurately identified as it can be related relative to the fluorescent fiducials.

In an embodiment, the method is performed using a charged particle device including an electron microscope and a focused ion beam. The method comprises the step of identifying the region of interest using the electron microscope. The method comprises the step of creating the sample using the focused ion beam, wherein the focused ion beam is used as a micromachining tool for creating the sample.

In a further embodiment, the method comprises the step of identifying the fluorescent fiducials using the electron microscope. Additionally, the method may comprise the step of identifying the fluorescent fiducials using the focused ion beam. The fluorescent fiducials that are positioned onto the sample area are visible in both the electron microscope (SEM) and the focused ion beam (FIB), and thus the milling position of the region of interest can be easily determined.

In an embodiment, the method comprises the step of imaging said sample area for determining at least one fiducial location, and subsequently placing said at least one fluorescent fiducial at said corresponding at least one fiducial location. In this embodiment, the fiducial location is determined before placing the fluorescent fiducial. This allows the fluorescent beads to be placed at a specific location that is relevant to the region of interest, rather than being placed at a random location due to the fiducials being added to the specimen beforehand. The imaging in this step may be done, in an embodiment, using the electron microscope.

In an embodiment, the method is performed in a Focused Ion Beam Scanning Electron Microscope (also referred to as Dual Beam System) that includes both a focused ion beam (FIB) and a scanning electron microscope, and that additionally includes an integrated fluorescent light microscope (iFLM). An example of a suitable dual beam system for performing the method as disclosed herein is the Aquilos 2 Cryo-FIB including the iFLM Correlative System, available from Thermo Fisher Scientific (Waltham, MA, USA). It is noted that other Focused Ion Beam Scanning Electron Microscopes including integrated Fluorescent Light Microscope (iFLM) can be used as well.

In an embodiment, the method comprises the step of micromachining the specimen for creating the sample, in particular by means of a focused ion beam. It should be noted that other techniques, including laser based techniques, can be used as well. In the specific embodiment, the use of a focused ion beam allows material to be micromachined and also to image the specimen being micromachined. The imaging with the micromachining technique allows a direct relation between the fiducials placed on the outer surface of the

In an embodiment, the method comprises the step of adding the at least one fluorescent fiducial at or near an outer perimeter of the region of interest. Placing the fluorescent fiducials at that position allows for more accuracy. Fiducials may be deliberately and purposefully placed, which increases the accuracy and visibility compared to random placement of fiducials.

In an embodiment, the step of adding the at least one fluorescent fiducial to the sample area comprises the step of changing a charge of the specimen at the fiducial location. When use is made of a dual beam system, the charge of the specimen can be changed by changing the mode of the dual-beam microscope from scanning electron beam to focused ion beam.

In an embodiment, the specimen comprises biological material. The method comprises the step of providing a vitrified specimen, i.e. a cryo-cooled specimen

In an embodiment, the method is used for creating a lamella shaped sample or a pillar shaped sample. Other shapes are conceivable as well, of course.

The method and apparatus of the disclosure will now be elucidated in more detail on the basis of exemplary embodiments and the accompanying schematic drawings, in which:
Fig. 1 - renders a longitudinal cross-sectional elevation view of an embodiment of a dual-beam charged particle beam system;
Fig. 2a-2b - show images of a specimen from which a sample needs to be produced;
Fig. 3a-c - show images of a specimen using an embodiment of the method as defined herein.
Fig. 4a-4c - show corresponding images obtained from practical experiments.

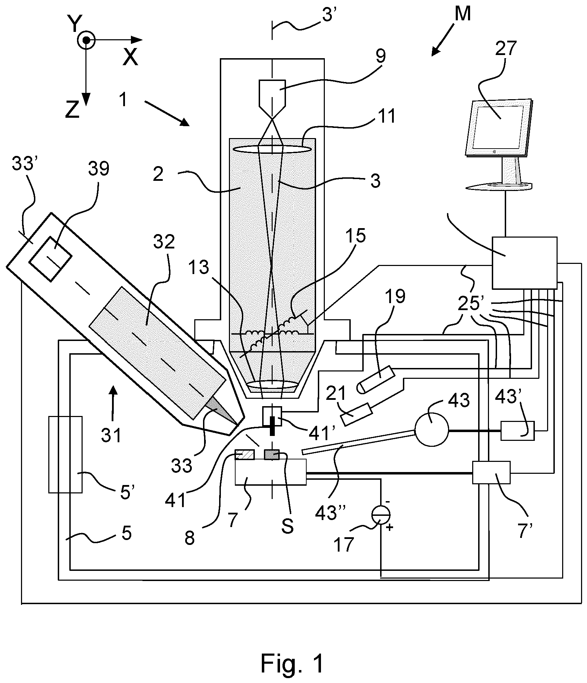

Fig. 1 shows a highly schematic depiction of an embodiment of a charged particle beam system. Here, a dual-beam charged particle microscope (CPM) is shown; more specifically, it shows an embodiment of a FIB-SEM. The microscope M comprises a particle-optical column 1, which produces a beam 3 of charged particles (in this case, an electron beam) that propagates along a particle-optical axis 3'. The column 1 is mounted on a vacuum chamber 5, which comprises a sample holder 7 and associated actuator(s) 7' for holding/positioning a sample 6. The vacuum chamber 5 is evacuated using vacuum pumps (not depicted). With the aid of voltage supply 17 the sample holder 7, or at least the sample S, may, if desired, be biased (floated) to an electrical potential with respect to ground. Also depicted is a vacuum port 5', which may be opened so as to introduce/remove items (components, samples) to/from the interior of vacuum chamber 5. A microscope M may comprise a plurality of such ports 5', if desired.

The column 1 (in the present case) comprises an electron source 9 (such as a Schottky gun, for example) and an illuminator 2. This illuminator 2 comprises (*inter alia*) lenses 11, 13 to focus the electron beam 3 onto the sample S, and a deflection unit 15 (to perform beam steering / scanning of the beam 3). The microscope M further comprises a processing unit 25 for controlling *inter alia* the deflection unit 15, lenses 11, 13 and detectors 19, 21, and displaying information gathered from the detectors 19, 21 on a display unit 27.

The detectors 19, 21 are chosen from a variety of possible detector types that can be used to examine different types of "stimulated" radiation emanating from the sample S in response to irradiation by the (impinging) beam 3. In the apparatus depicted here, the following (non-limiting) detector choices have been made:
- Detector 19 is a solid state detector (such as a photodiode) that is used to detect cathodoluminescence emanating from the sample S. It could alternatively be an X-ray detector, such as Silicon Drift Detector (SDD) or Silicon Lithium (Si(Li)) detector, for example;
- Detector 21 is an electron detector in the form of a Solid State Photomultiplier (SSPM) or evacuated Photomultiplier Tube (PMT) [e.g. Everhart-Thornley detector], for example. This can be used to detect backscattered and/or secondary electrons emanating from the sample S.

The skilled artisan will understand that many different types of detector can be chosen in a set-up such as that depicted, including, for example, an annular/segmented detector.

By scanning the beam 3 over the sample S, stimulated radiation -comprising, for example, X-rays, infrared/visible/ultraviolet light, secondary electrons (SEs) and/or backscattered electrons (BSEs)- emanates from the sample S. Since such stimulated radiation is position-sensitive (due to said scanning motion), the information obtained from the detectors 19, 21 will also be position-dependent. This fact allows (for instance) the signal from detector 21 to be used to produce a BSE image of (part of) the sample S, which image is basically a map of said signal as a function of scan-path position on the sample S.

The signals from the detectors 19, 21 pass along control lines (buses) 25'; are processed by the processing unit 25; and displayed on display unit 27. Such processing may include operations such as combining, integrating, subtracting, false colouring, edge enhancing, and other processing known to the skilled artisan. In addition, automated recognition processes (e.g. as used for particle analysis) may be included in such processing.

In addition to the electron column 1 described above, the microscope M also comprises an ion-optical column 31. This comprises an ion source 39 and an illuminator 32, and these produce/direct an ion beam 33 along an ion-optical axis 33'. To facilitate easy access to sample S on holder 7, the ion axis 33' is canted relative to the electron axis 3'. As hereabove described, such an ion (FIB) column 31 can, for example, be used to perform processing/machining operations on the sample S, such as incising, milling, etching, depositing, *etc.* Alternatively, the ion column 31 can be used to produce imagery of the sample S. It should be noted that ion column 31 may be capable of generating various different species of ion at will, e.g. if ion source 39 is embodied as a so-called NAIS source; accordingly, references to ion beam 33 should not necessarily been seen as specifying a particular species in that beam at any given time - in other words, the beam 33 might comprise ion species A for operation A (such as milling) and ion species B for operation B (such as implanting), where species A and B can be selected from a variety of possible options.

Also illustrated is a Gas Injection System (GIS) 43, which can be used to effect localized injection of gases, such as etching or precursor gases, *etc.*, for the purposes of performing gas-assisted etching or deposition. Such gases can be stored/buffered in a reservoir 43', and can be administered through a narrow nozzle 43", so as to emerge in the vicinity of the intersection of axes 3' and 33', for example.

The charged particle beam system is arranged for working with the biological sample at cryogenic temperatures.

It should be noted that many refinements and alternatives of such a set-up will be known to the skilled artisan, such as the use of a controlled environment within (a relatively large volume of) the microscope M, e.g. maintaining a background pressure of several mbar (as used in an Environmental SEM or low-pressure SEM).

In any event, the Charged Particle Beam system as disclosed in Fig. 1 comprises:
- A sample holder 7, for holding a (biological) sample S that is provided on a specimen carrier;
- An ion beam column 31, for producing a focused ion beam (FIB) that propagates along an ion axis 33' onto said biological sample for creating a lamella in said sample;
- A charged particle beam column 1, for producing a charged particle beam that propagates along a charged particle beam axis 3' onto said biological sample;
- A detector 21, for detecting radiation emanating from said biological sample in response to irradiation by said ion beam and/or said charged particle beam;
- A processing unit 25, for at least partially controlling operation of said microscope. The processing unit 25 may be arranged for performing at least parts of the method as described herein.

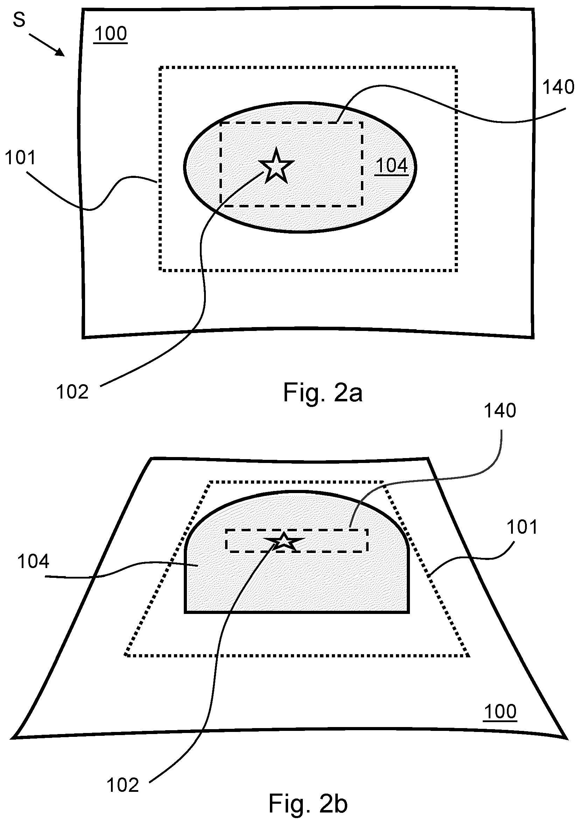

Fig. 2a-2b schematically show a top view (Fig. 2a) and a 3D-perspective view (Fig. 2b) of specimen S (also referred to as bulk sample). Figs. 2a and 2b show a relatively small part of a specimen carrier 100, which specimen carrier can be an EM grid (as known to those skilled in the art). As can be seen, especially in Fig. 2b, material 104 is provided on top of the specimen carrier 100. The material 104 comprises a region of interest 102 that is to be included in a sample to be formed by means of the method as described herein. The sample to be studied in the charged particle microscope is thus created out of a bigger specimen (or bulk sample) S.

The sample can be a lamella 140, for example, or a pillar (not shown) or any other shape that is conceivable and useful for study in a charged particle microscope. Those shapes will be apparent to those skilled in the art.

To create the smaller sample 140 out of the specimen S, the user normally scans and examines larger parts of the specimen S using an electron microscope, for example. Upon exploring the specimen, the user may encounter the material 104 from which a sample can be made. Having found the material 104, the user implicitly establishes a sample area: a region 101 of the specimen S surrounding the material 104 from which a sample can be made.

Note that the sample area 101 is indicated with a dotted line in Fig. 2a and 2b, and its actual size and shape is not important, as long as the sample area 101 comprises the region of interest 102.

Fig. 2a and 2b thus show, summarized, a specimen S on a specimen carrier 100, said specimen comprising a sample area 101 having material 104 from which a sample 140 for use in a Charged Particle Microscope M can be created, said sample area 101 comprising a region of interest 102 that is to be included in said sample 140.

Once the user locates the sample area 101 on the specimen carrier 100 and identifies the region of interest 102 in the sample area 101, the user may want to create the sample from said material 104, including said region of interest 102. This step can be done by creating a lamella 140 or a pillar shaped sample, for example, using a milling technique.

Traditionally, the sample area 101 with the region of interest 102 is identified using the Scanning Electron Microscope, using a view that is similar to the view shown in Fig. 2a. Once the region of interest 102 is identified, the user switches to the Focused Ion Beam view, which allows the preparation of the lamella 140.

As can be seen in Fig. 2a and 2b, it is challenging to align the information obtained in the two images to ensure the region of interest 102 is indeed identified correctly in the image that is used for the creation of the sample. Determining where to mill the material 104 for creating the lamella 140 so that indeed the final sample (lamella 140) contains the region of interest 102 is very difficult.

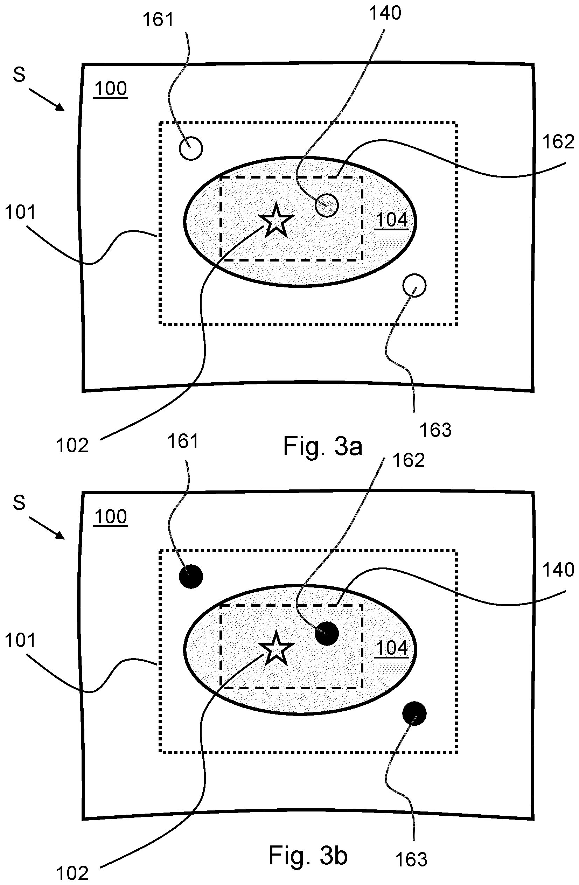

To address this challenge, the method as described herein uses an approach that will be discussed in more detail under reference to Fig. 3a to 3c.

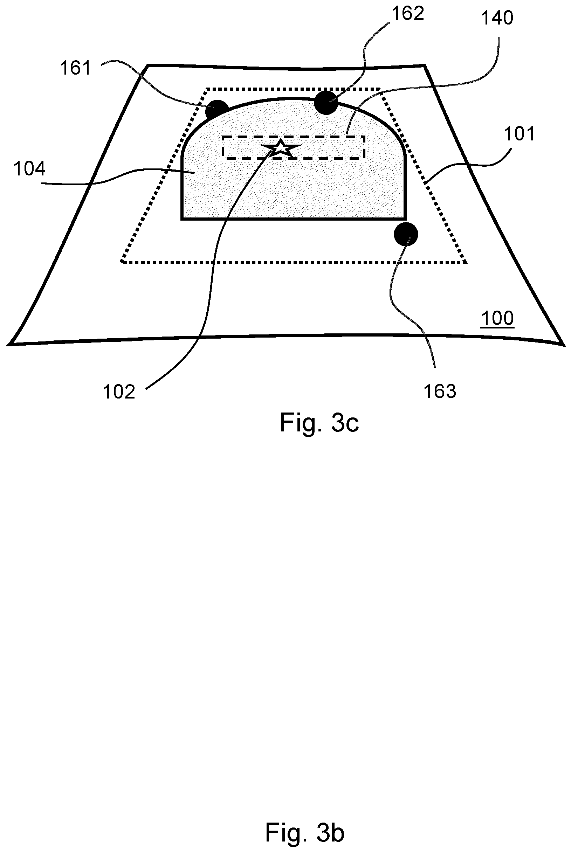

Fig. 3a shows the specimen S as shown in Fig. 2a. To improve alignment between images, the specimen S has now been provided with fluorescent fiducials 161-163. In the image in Fig. 3a, these fluorescent fiducials are hardly visible, which is true when the specimen S is imaged using Scanning Electron Microscopy, for example. However, the view can be improved when a fluorescent technique is used. As shown in Fig. 3b, the fiducials 161-163 are easily identifiable, as the fluorescent technique allows for improved contrast. Additionally, the fluorescent fiducials are also visible in the Focused Ion Beam image, as can be seen in Fig. 3c. Thus, alignment is possible between the image obtained using the fluorescent technique from Fig. 3b, and the image that is used to create the lamella 140. Thus, the fluorescent technique can be used for locating said fluorescent fiducial 161-163, with which the step of identifying said region of interest 102 can be subsequently performed.

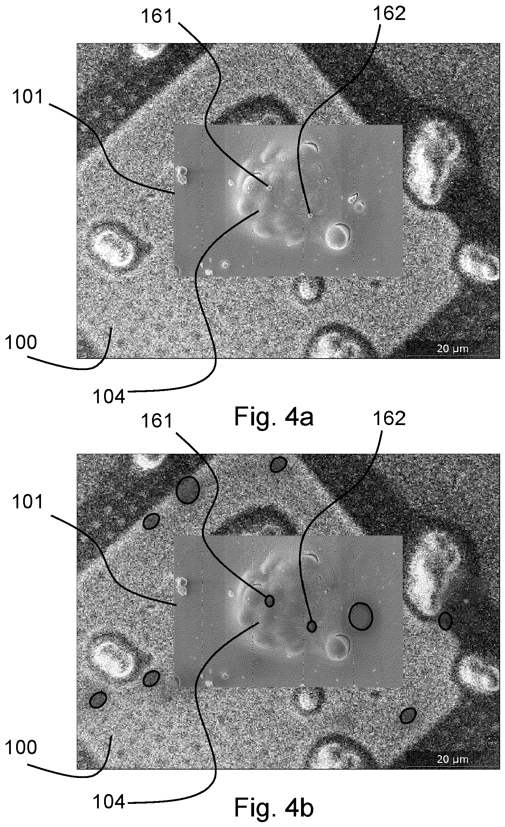

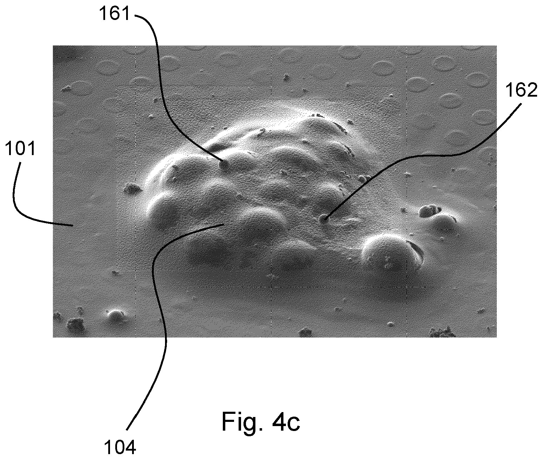

Fig. 4a to 4c show actual Electron Microscope images (Fig. 4a and 4b) and a focused ion beam image (Fig. 4c), using the technique and method as described herein.

Fig. 4a shows the Electron Microscope image, where two fiducials 161, 162 have been placed. Even though these fiducials are fluorescent, they are hardly visible for a user in the SEM image. Thus, Fig. 4b provides a SEM including fluorescence image of the same part of the sample. The fluorescent parts of the sample will lighten up, normally with a coloured hue value, such as blue. For clarification purposes, the fluorescent parts of this image have been manually indicated using oval shapes, as the hue is not visible in black-and-white images. From here, the fiducials 161, 162 are clearly visible.

It can be seen in Fig. 3a-3c and Fig. 4a-4c, that the fluorescent fiducials may be placed inside the sample area 101. The fiducials may be placed on the material 104 to be removed, see fiducial 162, whilst other fiducials 161, 163 are placed on the sample carrier 100. Fiducial 162 is placed closer to the region of interest 102, and is in fact added at or near an outer perimeter of the region of interest 102.

It is noted that the specimen S with the sample area 101 may be imaged to determine the location of the at least one fluorescent fiducial 161-163. The fluorescent fiducial may then be placed at said corresponding at least one fiducial location. For example, the image obtained in Fig. 2a may be used to determine where one or more fiducials need to be placed. Then a fiducial placing technique, which are known to those skilled in the art, can be used to place to fiducials 161-163 within the sample area 101, see Fig. 3A. An advantageous placement technique, which is part of embodiments of the present disclosure, comprises the step of changing a charge of the specimen at the fiducial location. By changing the charge the fiducial will adhere to the desired location more easily. Changing the charge can easily be done, for example, by changing the mode of a dual-beam microscope from the scanning electron microscope to the focused ion beam.

The determination of the location for the fiducials may include determining coordinates of the fiducials 161-163, which can be done before or after placement of the fiducials. Once the fiducials are placed, a fluorescent technique can be used to visualize the exact placed location of the fluorescent fiducials, see Fig. 3b. Then the location of the fluorescent fiducials can be noted, and aligned with the view obtained in the focused ion beam step, see Fig. 3c.

As noted, the method as described herein may include the step of micromachining the specimen for creating the sample, such as lamella 140. Here in particular, a focused ion beam can be used, although other means are conceivable as well, including, for example, any laser based techniques.

The method as described herein can advantageously be performed in a dual-beam microscope comprising a fluorescent module, said dual-beam microscope comprising a focused ion beam and a scanning electron beam. A suitable microscope is the Aquilos 2 Cryo-FIB, available from FEI company, Hillsboro, part of Thermo Fisher Scientific.

The desired protection is conferred by the appended claims.

## Claims

1. A method for creating a sample for use in a Charged Particle Microscope (CPM), the method comprising the steps of:
- Providing a specimen on a specimen carrier, said specimen comprising a sample area having material from which a sample for use in a Charged Particle Microscope can be created, said sample area comprising a region of interest that is to be included in said sample;
- Locating the sample area on said specimen carrier and identifying the region of interest; and
- Creating the sample from said material including said region of interest;
**Characterized by** the steps of:
- Adding at least one fluorescent fiducial to the sample area; and
- Using a fluorescent technique for locating said fluorescent fiducial for subsequently performing the step of identifying said region of interest.

2. Method according to claim 1, comprising the step of imaging said sample area for determining at least one fiducial location, and subsequently placing said at least one fluorescent fiducial at said corresponding at least one fiducial location.

3. Method according to claim 1 or 2, comprising the step of micromachining the specimen for creating the sample, in particular by means of a focused ion beam.

4. Method according to claim 1-3, comprising the step of adding the at least one fluorescent fiducial at or near an outer perimeter of the region of interest.

5. Method according to claim 1-4, comprising the step of determining coordinates of the at least one fluorescent fiducial added to the sample area.

6. Method according to claims 1-5, wherein the step of adding the at least one fluorescent fiducial to the sample area comprises the step of changing a charge of the specimen at the fiducial location.

7. Method according to claims 1-6, wherein the method is performed in a dual-beam microscope, said dual-beam microscope comprising a focused ion beam and a scanning electron beam.

8. Method according to claim 6 and 7, wherein the charge of the specimen is changed by changing the mode of the dual-beam microscope from scanning electron beam to focused ion beam.

9. Method according to claim 1-8, wherein the specimen comprises biological material.

10. Method according to claim 1-9, wherein the method is used for creating a lamella shaped sample or a pillar shaped sample.
